# EUROPÄISCHE PATENTSCHRIFT

(11) **EP 1 028 342 B1**
(45) Veröffentlichungstag und Bekanntmachung des Hinweises auf die Patenterteilung: **27.08.2003**
(21) Anmeldenummer: 00102490.0
(22) Anmeldetag: 05.02.2000
(51) Int. Cl.: G02B 7/00, G02B 7/02, G02B 7/182

(54) **Vorrichtung zum Kippen eines optischen Elements um zwei orthogonale Achsen**
Device for pivoting an optical element around two orthogonal axes
Dispositif pour basculer un élément optique autour de deux axes perpendiculaires

(30) Priorität: 12.02.1999 DE 19905779
(43) Veröffentlichungstag der Anmeldung: 16.08.2000
(73) Patentinhaber: Carl Zeiss, 89518 Heidenheim (Brenz) (DE)
(72) Erfinder: Weber, Ulrich, 89551 Koenigsbronn (DE)
(74) Vertreter: Lorenz, Werner, Dr.-Ing.

(56) Entgegenhaltungen:
- DD-A- 278 207
- US-A- 3 917 385
- US-A- 3 989 358
- US-A- 4 298 248

## Beschreibung

Die Erfindung betrifft eine Vorrichtung zum Kippen eines optischen Elements um wenigstens eine Achse, insbesondere einer Linse, nach dem Oberbegriff von Anspruch 1.

Eine Vorrichtung dieser Art ist in der US-A-3 917 385 beschrieben. Mit dieser vorbekannten Vorrichtung wird eine Deformationsentkoppelung zwischen dem Innenring und der Außenfassung für das optische Element erreicht.

Die DD 278 207 Al zeigt eine Fassung mit Justierelementen vorgesehen, auf denen einzeln gefasste optische Elemente in einem Füllfassungsrohr angeordnet sind. Die Justierelemente bestehen aus zwei unmittelbar aneinandergrenzende, ineinander und unabhängig voneinander verdrehbare Ringscheiben. Durch Drehungen der Ringscheiben, welche ein Keilringpaar bilden, lässt sich eine definierte Neigung der optischen Achse des optischen Elementes einstellen. Auf diese Weise können die optischen Achsen einzelner optischer Elemente mit hoher Genauigkeit zur mechanischen Achse eines Objektives ausgerichtet werden. Mit einer Vorrichtung dieser Art wird erreicht, dass die optische Achse eines einzelnen optischen Elementes, das mit der optischen Achse des Objektives, in das das optische Element eingebaut ist, nicht übereinstimmt, ausgerichtet werden kann.

Die Schiefstellung einer optischen Achse eines optischen Elementes kann z.B. durch Fertigungsungenauigkeiten oder Flanschunebenheiten eines Außenringes verursacht sein. Durch die Justierelemente nach der DD 278 207 Al lassen sich Abweichungen der optischen Achsen von optischen Elementen von der Achse des Objektives, aber nicht in der für Objektive für die Halbleiterlithographie geforderten hohen Genauigkeit korrigieren, da die Justage mit dem Keilringpaar reibungsbehaftet ist und somit sogenannten Stick-Slip- und Hystereseeffekte auftreten, die ein "Über"korrigieren zur Folge haben. Es wird daher immer eine etwas größere Verstellung wie erwünscht eingestellt. Zudem wird bei der vorbekannten Vorrichtung das optische Element jedoch von der Außenfassung nicht deformationsentkoppelt, so dass Verspannungen und Deformationen am Flansch auf das optische Element übertragen werden.

Der vorliegenden Erfindung liegt die Aufgabe zugrunde, eine Vorrichtung der eingangs erwähnten Art derart zu verbessern, dass ein optisches Element sehr genau wenigstens um eine Achse, insbesondere jedoch um zwei Achsen, geschwenkt werden kann, wobei das optische Element zwar gegenüber seiner Fassung oder seinem Außenring deformationsentkoppelt sein soll, die Vorrichtung selbst jedoch gegenüber der z-Achse (optische Achse) relativ steif sein soll.

Erfindungsgemäß wird diese Aufgabe durch die im kennzeichnenden Teil von Anspruch 1 genannten Merkmale gelöst.

Der Innenring, der das optische Element trägt, ist über insgesamt sechs Koppeln mit der Fassung bzw. dem Außenring verbunden. Vier Koppeln dienen dabei als sogenannte Stützkoppeln derart, dass sich der Innenring nur um die beiden senkrecht zueinander stehenden Kippachsen drehen kann. Die beiden anderen Koppeln, die als Stellkoppeln wirken, stützen jeweils die Drehmomente um die beiden Kippachsen (x-Achse und y-Achse) ab und dienen gleichzeitig zur Einstellung und Verstellung der Kippwinkel. Durch die Koppeln ist die Lagerung des Innenringes somit statisch bestimmt, wobei gleichzeitig auf diese Weise eine Deformationsentkoppelung des Innenringes gegenüber dem Außenring erreicht wird. Da die beiden Kippachsen senkrecht zueinander stehen, beeinflussen sich die Kippbewegungen nicht gegenseitig, weshalb Nachkorrekturen bei Verstellung in einer Richtung nicht notwendig werden.

Trotz der Deformationsentkoppelung lässt sich die Vorrichtung jedoch in z-Achse durch die erfindungsgemäße Neigung bzw. Schrägstellung der Stützkoppeln in einem Winkel α zur z-Achse relativ steif und zwar in Abhängigkeit von der Größe des Winkels α einstellen.

Wenn die beiden Kippachsen durch die z-Achse, d.h. bei einem optischen Element als Gegenstand durch die optische Achse verlaufen, wird ein Höhenversatz des optischen Elementes beim Kippen vermieden.

Die Ausgestaltung der Stützkoppeln kann beliebig sein. So können hierfür z.B. Festkörpergelenke, Kugelgelenke oder ähnliches verwendet werden, wobei die Verbindung mit dem Innenring und dem Außenring jeweils über ein Gelenk bzw. eine einstellbare oder nachgiebige Verbindung erfolgen kann.

Bei aus der Praxis bekannten Kippmanipulatoren, die auf einer Dreipunkt- oder Hexapodlagerung des Innenrings im Außenring basieren, erfährt beim Kippen das optische Element wegen der zur optischen Achse windschief liegenden Kippachsen einen Höhenversatz, der durch Nachkippen um andere Kippachsen wieder herausgestellt werden muss. Da bei der erfindungsgemäßen Vorrichtung die beiden Kippachsen die optische Achse des optischen Elementes schneiden können, tritt in diesem Fall kein Axialversatz beim Kippen auf.

Bei bekannten Kippmanipulatoren, ausgenommen kardanischen Aufhängungen, beeinflussen sich weiterhin die Kippbewegungen gegenseitig, da die Kippachsen nicht senkrecht zueinander stehen. Bei der erfindungsgemäßen Vorrichtung hingegen stehen die Kippachsen senkrecht zueinander, so dass keine gegenseitige Beeinflussung der Kippbewegungen gegeben ist.

Erfindungsgemäß ist der Verstellbereich so gewählt, dass der Kippwinkel zwischen Innenring und Außenring, der bei einer Außenringdeformation, z.B. durch Anschrauben des Außenrings auf eine unebene Unterlage, durch die statisch bestimmte Lagerung entsteht, korrigiert werden kann. Denkbar ist auch eine gezielte Verkippung des Innenringes, wobei aus Gründen der Praktikabilität, z.B. Festkörpergelenke, im allgemeinen Verkippungen sich auf kleinere Winkelbereiche beschränken würden.

Weitere vorteilhafte Ausgestaltungen und Weiterbildungen ergeben sich aus den übrigen Unteransprüchen und aus dem nachfolgend anhand der Zeichnung prinzipmäßig dargestellten Ausführungsbeispiel.

Es zeigt:
- Figur 1: schematisch eine perspektivische Darstellung der erfindungsgemäßen Vorrichtung mit einem Innenring, Stütz- und Stellkoppeln und einem Außenring,
- Figur 2: eine Draufsicht auf die Vorrichtung nach Figur 1 in Prinzipdarstellung,
- Figur 3: eine Draufsicht auf die erfindungsgemäße Vorrichtung in einer konstruktiven Ausgestaltung,
- Figur 4: einen Schnitt nach der Linie IV-IV der Figur 3 in vergrößerter Darstellung,
- Figur 5: ausschnittsweise eine Prinzipdarstellung einer Stellkoppel mit Verstelleinrichtung,
- Figur 6: einen Schnitt nach der Linie VI-VI der Figur 3 in vergrößerter Darstellung,
- Figur 7: eine vergrößerte Darstellung einer Stützkoppel mit Kugelgelenken,
- Figur 8: eine vergrößerte Darstellung einer Stützkoppel mit Festkörpergelenken, und
- Figur 9: eine vergrößerte Darstellung einer Stützkoppel mit Kugelflächen.

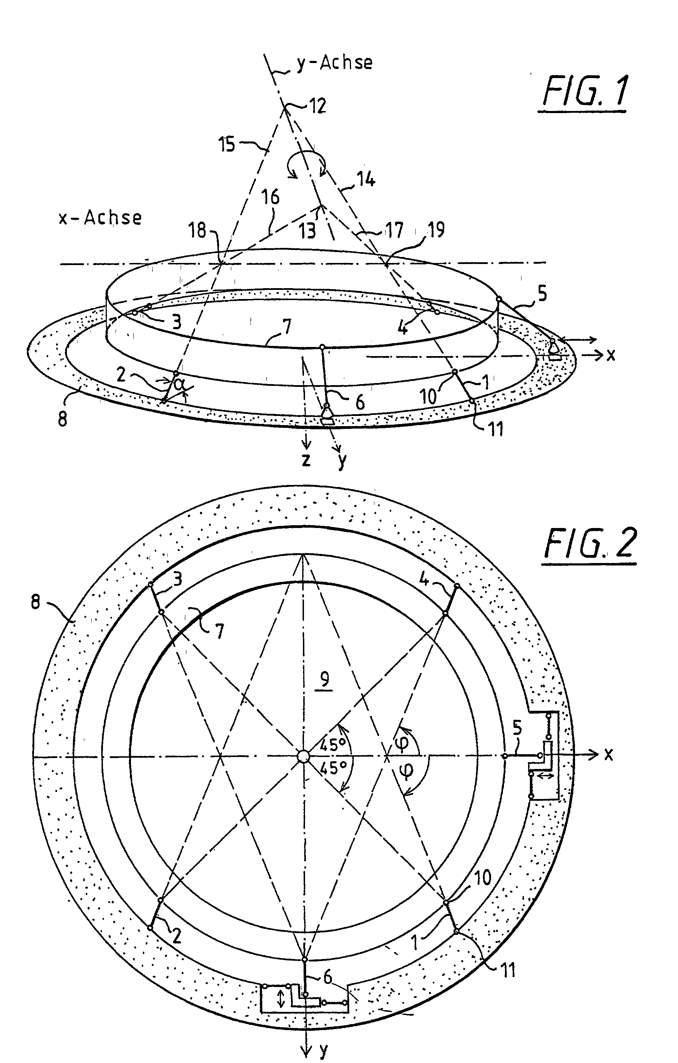

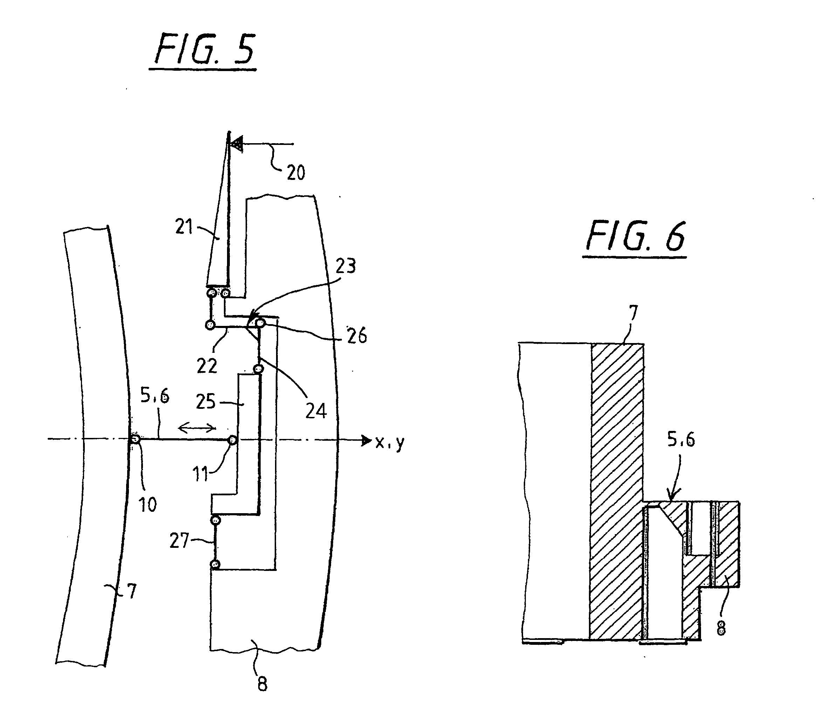

Vier Stützkoppeln 1, 2, 3 und 4 und zwei Stellkoppeln 5 und 6 verbinden einen Innenring 7 mit einem Außenring 8. Der Innenring 7 trägt ein optisches Element 9 (in der Figur 1 aus Übersichtlichkeitsgründen nicht dargestellt). Jede der sechs Koppeln besitzt ein Gelenk 10, mit welchem die dazugehörige Koppel mit dem Innenring 7 und ein weiteres Gelenk 11, mit welchem ebenfalls die dazugehörige Koppel mit dem Außenring 8 oder einen Verstellmechanismus (siehe Figur 5, Bezugszeichen 21-27), der vom Außenring 8 gehalten wird, verbunden ist. Die Gelenke 10 und 11 können als Kugelgelenke, Festkörpergelenke oder in ähnlicher Weise ausgebildet sein.

Durch die Verbindung des Innenringes 7 mit dem Außenring 8 über die sechs Koppeln ist der Innenring 7 von Fertigungsungenauigkeiten des Außenringes 8 bzw. der Fassung und von dessen Deformationen entkoppelt. Gleichzeitig kann über die sechs Koppeln jedoch eine Justage um zwei senkrecht zueinander stehende Achsen, nämlich die x-Achse und die y-Achse, vorgenommen werden. Dies geschieht auf folgende Weise:

Durch die vier Stützkoppeln 1, 2, 3 und 4 wird der Innenring 7 derart auf dem Außenring 8 getragen, dass für den Innenring 7 nur noch zwei Freiheitsgrade, nämlich um die x-Achse und die y-Achse, gegeben sind. Diese beiden Achsen stellen die Kippachsen dar. Die y-Achse als Dreh- bzw. Kippachse ergibt sich dabei durch die Schnittpunkte 12 und 13, deren Verbindungslinie die y-Achse darstellt. Der Schnittpunkt 12 ergibt sich hierfür aus der Verlängerungslinie 14 der Stützkoppel 1 mit der Verlängerungslinie 15 der Stützkoppel 2 und der Schnittpunkt 13 ergibt sich aus der Verlängerungslinie 16 der Stützkoppel 3 mit der Verlängerungslinie 17 der Stützkoppel 4.

In ähnlicher Weise wird die Dreh- bzw. Kippachse, welche 90° dazu liegt, nämlich der x-Achse, mittels einer Verbindungslinie durch die Schnittpunkte 18 und 19 gebildet. Der Schnittpunkt 18 ergibt sich dabei durch die Verlängerungslinie 15 der Stützkoppel 2 mit der Verlängerungslinie 16 der Stützkoppel 3. Der Schnittpunkt 19 ergibt sich durch die Verlängerungslinie 14 der Stützkoppel 1 mit der Verlängerungslinie 17 der Stützkoppel 4. Anders ausgedrückt: Die Stützkoppeln 1 und 2 bilden im Ausführungsbeispiel eine Ebene und die Stützkoppeln 3 und 4 bilden die andere Ebene, wobei die Schnittgerade beider Ebenen die Kippachse darstellt.

Bei dieser Ausgestaltung und Anordnung der Stützkoppeln 1 bis 4 gehen die Dreh- bzw. Kippachsen x-, y-Achse, genau durch die z-Achse. Dabei liegt ein Anstellwinkel α als Stützkoppelanstellwinkel der Winkel zwischen der Stützkoppel 1, 2, 3 oder 4 und der xy-Ebene. Wie ersichtlich, sind die beiden Kippachsen gemäß Ausführungsbeispiel nach der Figur 1 jedoch in der Höhe versetzt zueinander, weshalb sich bei einer Kippung ein Lateralversatz einstellt. Je näher die beiden Kippachsen zum Innenring 7 liegen, d.h. je flacher ein Anstellwinkel α der Stützkoppeln zur xy-Ebene ist, desto geringer wird der Lateralversatz. Nachteilig ist jedoch, dass dabei die Steifigkeit der Vorrichtung in z-Richtung leidet. Umgekehrt, je steiler bzw. je größer die Winkel α der Stützkoppeln zur z-Achse sind, desto weiter liegen die Kippachsen vom Außenring 8 weg und desto steifer wird die Vorrichtung in z-Richtung, wobei jedoch entsprechend der Lateralversatz zunimmt. Dies bedeutet, in der Praxis wird man die Anstellwinkel α der Stützkoppeln entsprechend den gewünschten Anforderungen wählen.

Die Stellkoppel 5, welche auf der x-Achse vom Innenring 7 bzw. Außenring 8 liegt, stützt Drehmomente um die y-Achse ab. Der Kippwinkel des Innenringes 7 um die y-Drehachse kann durch ein Verschieben der Stellkoppel 5 in x-Richtung gegenüber dem Außenring 8 eingestellt werden.

Die Stellkoppel 6 stützt die Drehmomente um die x-Achse ab und befindet sich hierzu auf der y-Achse des Außenringes 8. Durch ein Verschieben der Stellkoppel 6 in y-Richtung gegenüber dem Außenring 8 kann der Kippwinkel des Innenringes 7 um die x-Achse eingestellt werden.

Ein Anordnungswinkel ϕ beschreibt die Anordnung der Stützkoppeln 1 bis 4 zum Innenring 7 in der Draufsicht (siehe Figur 2). Der Anordnungswinkel ϕ ist der Winkel zwischen der Tangente des Ansatzpunktes der Stützkoppel 1, 2, 3 bzw. 4 am Innenring 7 und der in die xy-Ebene projizierte Stützkoppel. Der Anordnungswinkel ϕ der Stützkoppel 1, 2, 3 bzw. 4 legt damit die axiale Lage der Kippachsen zueinander fest. Da der Anstellwinkel α der Stützkoppeln 1; 2, 3, 4 die Höhe der Kippachsen vom Außenring 8 bestimmt, teilt der Anordnungswinkel ϕ den Anstellwinkel α in einen Anstellwinkel für die x-Kippachse, der die Projektion des Anstellwinkels α auf die yz-Ebene ist, und in einen Anstellwinkel für die y-Kippachse, der die Projektion des Anstellwinkels auf die zx-Ebene ist, auf.

Sind die Stützkoppeln 1, 2, 3, 4 radial zum Innenring ausgerichtet (ϕ = 90°), so sind die projizierten Winkel gleich groß, und damit liegen die x- und y-Kippachsen gleichweit vom Außenring 8 entfernt. Die x- und y-Kippachsen schneiden sich und spannen dann eine horizontale Ebene auf. In diesem Fall liegt auch für beide Kipprichtungen ein gleicher Lateralversatz vor.

Die Stützkoppeln 1 bis 4 können von tangential (ϕ = 0°) bis zu radial (ϕ = 90°) an den Innenring 7 angeordnet werden.

Bei tangentialer Anordnung der Stützkoppeln 1 bis 4 liegt eine Kippachse oberhalb des Außenringes 8, während die andere Kippachse im gleichen Abstand unterhalb des Außenringes 8 liegt (nicht dargestellt).

Dies bedeutet, die beiden Kippachsen, nämlich die x- und y-Achsen, liegen auf diese Weise auf verschiedenen Seiten des Innenringes 7 bzw. Außenringes 8. Der Vorteil dieser Ausgestaltung liegt in einer platzsparenden Anordnung.

Je nach den Anforderungen an die Vorrichtung und den Platzverhältnissen sind im Bedarfsfalle sämtliche Anordnungswinkel ϕ zwischen radial und tangential möglich.

Bei der Wahl des Anordnungswinkels ϕ der Stützkoppel 1, 2, 3, 4 sollte berücksichtigt werden, dass nichtschneidende Kippachsen unterschiedliche Lateralversätze in den beiden Kipprichtungen bewirken.

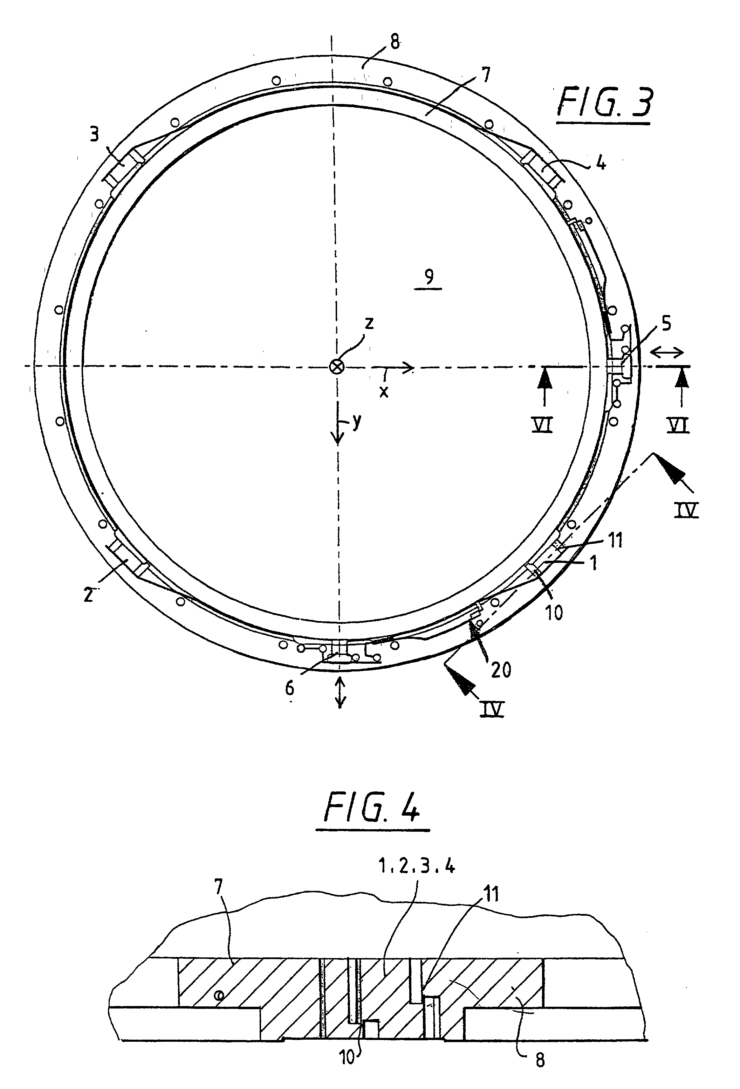

In den Figuren 2 bis 6 ist in der Draufsicht in Prinzipdarstellung eine mögliche Ausgestaltung für die Stützkoppeln 1, 2, 3 und 4 und die Stellkoppeln 5 und 6 dargestellt. Wie ersichtlich, liegen die Stützkoppeln 1, 2, 3, 4 stets auf Geraden von 45° zum Innenring. Wie weiterhin ersichtlich, sind die Stützkoppeln 1, 2, 3 und 4 jeweils über das Gelenk 11 mit dem Außenring 8 und das Gelenk 10 mit dem Innenring verbunden. Die Figur 4 zeigt einen Schnitt nach der Linie IV-IV der Figur 3 mit einer Ausgestaltung der Stützkoppeln 1 bis 4 als Festkörpergelenke in vergrößerter Darstellung. Dabei sind auch die Gelenkpunkte 10, 11 erkennbar.

Die beiden Stellkoppeln 5 und 6 können entweder durch einen direkten Angriff an diesen verstellt werden oder durch Stellschrauben 20 (siehe Prinzipdarstellung in Figur 5), welche über eine Parallelführung mit einem Übersetzungsverhältnis auf die Verstellung der Stellkoppeln 5 und 6 in Richtung der x-bzw. y-Achse (siehe Pfeile) einwirken.

Die nur beispielsweise dargestellte Parallelführung weist einen Übersetzungshebel 21 auf, an dem die Stellschraube 20 angreift. Der Übersetzungshebel 21 ist gelenkig mit einem Ansatz 22 eines Winkelhebels 23 verbunden, welcher wiederum mit seinem anderen Schenkel als Antriebsschenkel 24 mit einer Stellplatte 25 der Stellkoppel 5 bzw. 6 verbunden ist. Der Stellwinkel 23 ist über eine gelenkige Verbindung 26 mit dem Außenring 8 verbunden. Über einen weiteren Schenkel 27 ist die Stellplatte 25 nochmals gelenkig mit dem Außenring 8 verbunden. Der Stellwinkel 23, die Stellplatte 25 und der Schenkel 27 bilden eine Parallelführung für das Gelenk 11 der Stellkoppel 5 bzw. 6. Wie ersichtlich, führen Verstellbewegungen der Stellschraube 20 in Pfeilrichtung zu einer Verschiebung der Stellkoppel 5 in x-Richtung und der Stellkoppel 6 in y-Richtung. Auf diese Weise erhält man bei einem großen Verstellweg mit der Stellschraube 20 eine sehr feine Verschiebung bzw. Anstellung der Stellkoppeln 5 und 6 in x- bzw. y-Richtung.

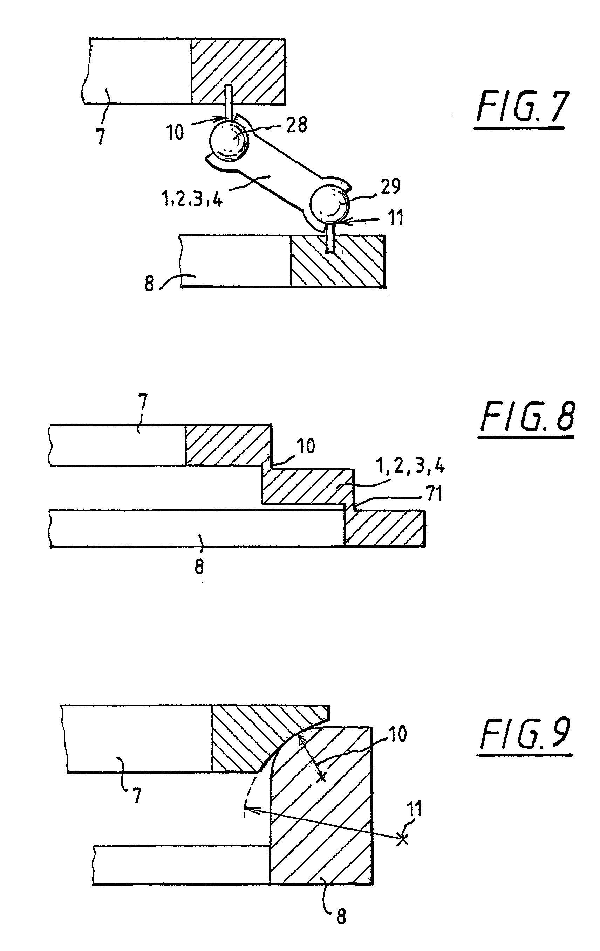

Figur 6 zeigt als Ausschnittsvergrößerung des Schnittes VI-VI der Figur 3 eine konstruktive Ausgestaltung der Stellkoppel 5 bzw. 6 mit Festkörpergelenken 10, 11.

Die Figuren 7 bis 9 zeigen einige Ausgestaltungen von Stützkoppeln, welche jedoch nur als beispielsweise anzusehen sind.

Die in der Figur 7 dargestellte Stützkoppel 1, 2, 3 oder 4 ist mit reibungsarmen Kugelgelenken 28 und 29 versehen, welche die Gelenke 10 und 11 bilden.

Die Figur 8 zeigt eine Ausführung der Stützkoppeln 1 bis 4 mit Festkörpergelenken 10 und 11, wie sie in dem Ausführungsbeispiel nach den Figuren 1 bis 6 dargestellt sind und zwar durch Bildung von elastischen, dünnen Übergangsstellen zwischen dem einstückig gefertigten Innenring 7 und Außenring 8.

Die Figur 9 zeigt eine Spezialart, wobei die Stützkoppeln 1 bis 4 durch Kugelflächen zwischen dem Innenring 7 und dem Außenring 8 gebildet werden bzw. deren Funktion übernehmen. Dabei werden die Gelenke 10 und 11 durch die Krümmungsflächen am Innenring 7 und am Außenring 8 gebildet, wobei ein Krümmungsradius kleiner ist als der andere Krümmungsradius. Die kinematischen Gelenkpunkte 10 und 11 dieser Verbindung liegen dabei auf den Krümmungsmittelpunkten der Kugelflächen.

Bei den vorstehend beschriebenen Ausführungsbeispielen besitzt die Vorrichtung jeweils vier Stützkoppeln 1 bis 4, deren Ansatzpunkte am Innenring 7 gleichmäßig am Umfang verteilt sind, und zwei Stellkoppeln 5 und 6, die einen Winkel von 90° einschließen.

Bei einer Ausführung der Stützkoppeln 1 bis 4 und der Stellkoppeln 5 und 6 mit Festkörpergelenken können für eine symmetrische Deformation des Innenringes 7 durch die Festkörpergelenk-Biegemomente zusätzlich Ausgleichskoppeln angebracht werden. Derartige Ausgleichskoppeln können umfangseitig gegenüber den Stellkoppeln 5 und 6 angeordnet werden, besitzen jedoch selbst keine Stellfunktion. Selbstverständlich können die Ausgleichskoppeln jedoch auch noch an einer anderen Stelle angeordnet werden. Ersetzt man die Festkörpergelenke derartiger Ausgleichskoppeln durch ideale Gelenke, müssen die Ausgleichskoppeln am Innenring 7 alle sechs Freiheitsgrade freigeben.

Obwohl vorstehend nur Vorrichtungen mit jeweils vier Stützkoppeln 1 bis 4 beschrieben sind, wird nachdrücklich darauf hingewiesen, dass auch im Rahmen der Erfindung andere Anzahlen, Anordnungen und Gestaltungen von Stützkoppeln möglich sind. So sind z.B. auch Einsatzfälle möglich, wobei nur zwei sich gegenüberliegende Stützkoppeln vorhanden sind, die jeweils um 90° versetzt zu Stellkoppeln, welche sich ebenfalls gegenüberliegen, angeordnet sind.

Als optisches Element kann statt einer Linse 9 selbstverständlich auch ein Spiegel oder ein anderes optisches Element vorgesehen sein, das deformationsentkoppelt wird.

## Patentansprüche

1. Vorrichtung zum Kippen eines optischen Elementes (9), insbesondere einer Linse, um wenigstens eine Achse, wobei das optische Element (9) von einem Innenring (7) getragen und über wenigstens drei Lagerpunkte mit einer Fassung oder einem Außenring (8) verbunden ist, wobei durch Justierelemente die Kippungen des optischen Elementes (9) um die senkrecht zur optischen Achse (z-Achse) liegenden Achsen einstellbar sind, wobei als Justierelemente mehrere Koppeln (1-6) vorgesehen sind, von denen ein Teil als Stützkoppeln (1-4) den Innenring (7) gegenüber dem Außenring (8) oder der Fassung so lagert, dass der Innenring (7) nur um zwei senkrecht zueinander stehende Kippachsen (x-, y-Achse) drehen kann, wobei zwei weitere Koppeln als Stellkoppeln (5, 6) Drehmomente um die senkrecht zueinander stehenden Kippachsen abstützen, und wobei durch Verstellen der Stellkoppeln (5, 6) die Kippwinkel einstellbar sind, **dadurch gekennzeichnet, dass** die Achsen der Stützkoppeln (1-4) zur optischen Achse mit einem Anstellwinkel (α) ungleich Null geneigt sind.

2. Vorrichtung nach Anspruch 1, **dadurch gekennzeichnet, dass** die Stützkoppeln (1-4) derart angeordnet sind, dass die Kippachsen (x-, y-Achse) auf verschiedenen Seiten des Gegenstandes liegen.

3. Vorrichtung nach Anspruch 2, **dadurch gekennzeichnet, dass** die Stützkoppeln (1-4) tangential am Innenring (7) angreifen.

4. Vorrichtung nach einem der Ansprüche 1 bis 3, **dadurch gekennzeichnet, dass** die Stützkoppeln (1-4) jeweils zwei Gelenke (10,11) aufweisen, über welche jeweils die Verbindung zwischen dem Innenring (7) und dem Außenring (8) oder der Fassung hergestellt ist.

5. Vorrichtung nach Anspruch 4, **dadurch gekennzeichnet, dass** die Gelenke (10,11) als Festkörpergelenke ausgebildet sind.

6. Vorrichtung nach Anspruch 4, **dadurch gekennzeichnet, dass** die Gelenke (10,11) als Kugelgelenke (28,29) ausgebildet sind.

7. Vorrichtung nach Anspruch 4, **dadurch gekennzeichnet, dass** die Gelenke (10,11) mit Kugelflächen am Innenring (7) und am Außenring (8) versehen sind.

8. Vorrichtung nach einem der Ansprüche 1 bis 7, **dadurch gekennzeichnet, dass** die Stellkoppeln (5,6) mit Einstellgliedern (15) versehen sind, durch die Übersetzungen des Verstellweges möglich sind.

9. Vorrichtung nach Anspruch 8, **dadurch gekennzeichnet, dass** als Einstellglieder Stellschrauben (15) vorgesehen sind, die über Übersetzungshebel (21-27) an den Stellkoppeln (5,6) angreifen.

10. Vorrichtung nach Anspruch 9, **dadurch gekennzeichnet, dass** das nicht mit dem Innenring (7) verbundene Ende der Stellkoppeln (5,6) über eine Parallelführung (24,25,27) mit dem Außenring (8) verbunden ist und die Übersetzungshebel (21,22) an der Parallelführung angreifen.

## Claims

1. Device for tilting an optical element (9), in particular a lens, about at least one axis, wherein the optical element (9) is carried by an inner ring (7) and is connected via at least three supporting points to a mounting or an outer ring (8), wherein the tilting of the optical element (9) about the axis lying perpendicular to the optical axis (z axis) can be adjusted by adjustment elements, wherein a plurality of coupling rods (1-6) are provided as adjustment elements, some of which are mounted as supporting coupling rods (1-4) for supporting the inner ring (7) relative to the outer ring (8) or mounting in such a way that the inner ring (7) can rotate only about two mutually perpendicular tilting axes (x axis, y axis), wherein two further coupling rods acting as adjustment coupling rods (5, 6) support torsional forces about the mutually perpendicular tilting axes, and wherein the tilting angles can be adjusted by altering the adjustment coupling rods (5, 6), **characterised in that** the axes of the supporting coupling rods (1-4) are inclined relative to the optical axis at an adjustment angle (α) not equal to zero.

2. Device according to claim 1, **characterised in that** the supporting coupling rods (1-4) are arranged so that the tilting axes (x axis, y axis) lie on different sides of the object.

3. Device according to claim 2, **characterised in that** the supporting coupling rods (1-4) engage tangentially on the inner ring (7).

4. Device according to one of claims 1 to 3, **characterised in that** the supporting coupling rods (1-4) in each case comprise two joints (10, 11) via which in each case the connection is made between the inner ring (7) and the outer ring (8) or the mounting.

5. Device according to claim 4, **characterised in that** the joints (10, 11) are formed as solid body joints.

6. Device according to claim 4, **characterised in that** the joints (10, 11) are formed as ball-and-socket joints (28, 29).

7. Device according to claim 4, **characterised in that** the joints (10, 11) are provided with spherical surfaces on the inner ring (7) and on the outer ring (8).

8. Device according to one of claims 1 to 7, **characterised in that** the adjustment coupling rods (5, 6) are provided with adjustment members (15) by means of which transmissions of the adjustment path are possible.

9. Device according to claim 8, **characterised in that** adjustment screws (15) are provided as adjustment members that engage the adjustment coupling rods (5, 6) via transmission levers (21-27).

10. Device according to claim 9, **characterised in that** the end of the adjustment coupling rods (5, 6) not connected to the inner ring (7) is connected via a parallel guidance means (24, 25, 27) to the outer ring (8) and the transmission levers (21, 22) engage the said parallel guidance means.

## Revendications

1. Dispositif pour basculer un élément optique (9), en particulier une lentille, autour d'au moins un axe, l'élément optique (9) étant porté par une bague intérieure (7) et relié à une monture ou à une bague extérieure (8) par l'intermédiaire d'au moins trois points de portée, dans lequel les basculements de l'élément optique (9) peuvent être réglés autour des axes s'étendant perpendiculairement à l'axe optique (axe z), et dans lequel il est prévu comme éléments d'ajustement plusieurs biellettes (1-6), dont certaines, constituant des biellettes de support (1-4), donnent appui à la bague intérieure (7) sur la bague extérieure (8) ou sur la monture de telle manière que la bague intérieure (7) puisse tourner seulement autour de deux axes de basculement (axe x, axe y) perpendiculaires entre eux, tandis que deux autres biellettes, jouant le rôle de biellettes de réglage (5, 6) forment le point de réaction pour les couples autour des axes de basculement perpendiculaires entre eux et que les angles de basculement peuvent être réglés par déplacement des biellettes de réglage (5, 6), **caractérisé en ce que** les axes des biellettes de support (1-4) sont inclinés sur l'axe optique d'un angle d'attaque (α) non nul.

2. Dispositif selon la revendication 1, **caractérisé en ce que** les biellettes de support (1-4) sont disposées de manière que les axes de basculement (axe x, axe y) soient situés sur différents côtés de l'objet.

3. Dispositif selon la revendication 2, **caractérisé en ce que** les biellettes de support (1-4) attaquent la bague intérieure (7) tangentiellement.

4. Dispositif selon l'une des revendications 1 à 3, **caractérisé en ce que** les biellettes de support (1-4) comportent chacune deux articulations (10, 11), par l'intermédiaire desquelles sont réalisées les liaisons entre la bague intérieure (7) et la bague extérieure (8) ou la monture.

5. Dispositif selon la revendication 4, **caractérisé en ce que** les articulations (10, 11) sont constituées par des articulations à corps solides.

6. Dispositif selon la revendication 4, **caractérisé en ce que** les articulations (10, 11) sont constituées par des articulations à rotule (28, 29).

7. Dispositif selon la revendication 4, **caractérisé en ce que** les articulations (10, 11) sont pourvues de surfaces sphériques sur la bague intérieure (7) et sur la bague extérieure (8).

8. Dispositif selon l'une des revendications 1 à 7, **caractérisé en ce que** les biellettes de réglage (5, 6) sont pourvues d'organes de réglage (15) par lesquels il est possible de modifier les rapports de transmission de la course de déplacement.

9. Dispositif selon la revendication 8, **caractérisé en ce que** des vis de réglage (15), qui attaquent les biellettes de réglage (5, 6) par l'intermédiaire de leviers de transmission (21-27), sont prévues comme organes de réglage.

10. Dispositif selon la revendication 9, **caractérisé en ce que** l'extrémité des biellettes de réglage (5, 6) qui n'est pas reliée à la bague intérieure (7) est reliée à la bague extérieure (8) par l'intermédiaire d'un guidage parallèle (24, 25, 27) et les leviers de transmission (21, 22) attaquent le guidage parallèle.
